# EUROPEAN PATENT APPLICATION

(11) **EP 1 063 872 A2**
(43) Date of publication of application: **27.12.2000**
(21) Application number: 00305088.7
(22) Date of filing: 15.06.2000
(51) Int. Cl.: H05K 1/18, H01M 2/10

(54) **Electrical circuit arrangements**

(30) Priority: 26.06.1999 GB 9914907
(71) Applicant: ROVER GROUP LIMITED, Warwick, Warwickshire CV34 6RG (GB)
(72) Inventor: Greenwood, Jeremy John, Sutton Coldfield, W-Midlands, B73 5 LL (GB); Talbot, Kevin Trevor, Lichfield, Staffordshire, WS13 7JJ (GB)
(74) Representative: Wilson, Alan Stuart

(57) **Abstract**

An electrical circuit is disclosed which is suitable for use in a portable electrical appliance 10, such as might be used as a remote transponder for a vehicle security system. The circuit includes a coin-cell battery 16 which is connected to a printed circuit board (PCB) 12 by soldered weld-tags 18, 20. A support layer 24 is laminated to one face of the PCB 12 and has a recess 26 defined in it. The battery 16 sits in the recess 26, which provides lateral support to the battery 16 so that the likelihood of displacement of the battery 16 substantially along the plane of the support layer 24 in the event of shock is reduced.

## Description

This invention relates to electrical circuit arrangements and in particular, but not exclusively, to an electrical circuit arrangement which is suitable for use in a portable appliance such as a transponder of the type which might be used to control part of a vehicle security system.

It is known to provide the power for an electrical circuit by including in it a battery or other self-contained power supply. It is a problem with some such arrangements that the battery can become dislodged, or even disconnected, as a result of shock or vibration. This might result in reduced efficiency and/or reliability of the circuit and therefore of the portable appliance.

One arrangement in which this problem might be suffered is a remote transponder unit used to control a security system of a vehicle. For example, some known transponders include a printed circuit board (PCB) which is supplied with power by a battery included in the transponder and the electrical connection to the PCB from the battery can be broken in the event of shock or extreme vibration.

US 5,229,641 discloses a semiconductor card in which a battery and its associated PCB are embedded using a thermosetting resin. The battery is housed in a battery receiving portion, this component being stuck to the PCB with an adhesive before application of the resin. In this arrangement, however, it is necessary to produce the battery receiving portion as a separate component, stick it to the PCB and then add the resin, all of which adds up to a complicated and lengthy process.

It is an object of this invention to provide an improved electrical circuit arrangement.

According to the invention there is provided an electrical circuit suitable for use in a portable electrical appliance, the circuit comprising a circuit board which includes a support means for supporting a power supply means which is connected to the circuit board, the support means comprising a substantially planar support layer having defined therein a recess which substantially complements a profile of the power supply means, such that a surface which at least in part defines the recess opposes lateral displacement of the power supply means substantially along a plane of said support layer, characterised in that the support layer is integrated with the circuit board.

The support layer may comprise a layer of the circuit board. The circuit board may comprise a printed circuit board (PCB) and the support layer may comprise a laminated layer of said printed circuit board (PCB).

The support layer may include at least one relief portion which is arranged to accommodate a connecting means for connecting the power supply means to the circuit board.

The recess may be defined as a blind hole or may be defined as a hole extending substantially through at least the support layer.

The power supply means may be adhesively bonded and/or soldered in place.

The circuit may be included in a remote control unit, which may comprise a remote transponder of a vehicle security system.

The invention will now be described by way of example only and with reference to the accompanying drawings, in which:

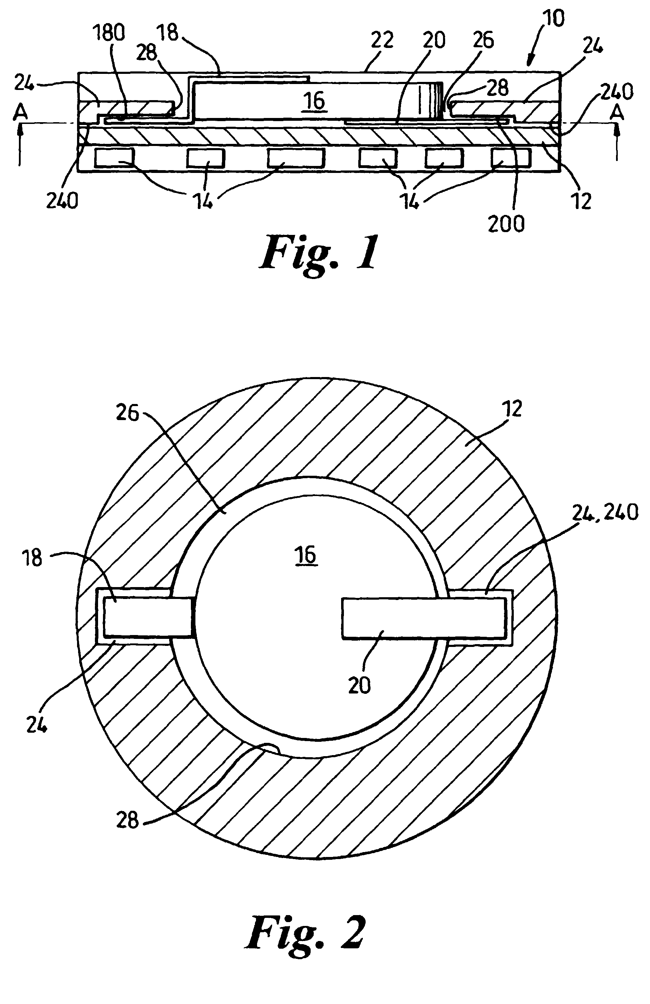

Figure 1 is a sectional side elevation through a circuit board according to the invention: and
Figure 2 is a sectional view through the circuit board of Figure 1 seen from the underside along the line A to A.

Referring to the figures, a portable electrical appliance in the form of a remote control unit 10 includes an electrical circuit comprising a printed circuit board (PCB) 12 on which are mounted a series of components 14 which provide the PCB 12 with its functionality.

Power for the PCB 12 is provided by a power supply means in the form of a battery 16, which is of the type known in the art as a "coin cell". The battery 16 has welded tags 18, 20 which are soldered to the PCB 12 such that the battery 16 can reliably supply the PCB 12 with power.

The battery 16 is held in place against the PCB 12 by a casing 22 which forms the housing of the control unit 10. In this manner, capture of the battery 16 between the PCB 12 and the casing 22 helps to reduce the likelihood of axial movement of the battery 16.

A power supply support means is provided and comprises a substantially planar laminated support layer 24 which defines a recess 26 and is bonded to the PCB 12 by lamination during manufacture. The recess 26 extends through the support layer 24 and is defined by a surface 28 of the support layer 24, such that the recess 26 substantially complements the radial profile of the battery 16.

The support layer 24 is provided with relief portions in the form of cut-outs/slots 180, 200 which complement the tags 18, 20 and face the side 240 of the support layer 24 which abuts the PCB 12. By connecting the battery 16 to the PCB 12 in this manner, there is no need to provide electrical connections or through-holes in the support layer 24 and production costs are kept down.

The surface 28 which defines the recess 26 can provide lateral support as necessary to the battery 16, and can thereby reduce the likelihood of lateral or radial displacement of the battery 16 in the event that vibration or shock is transmitted to the remote control unit 10.

The reduction in potential lateral displacement of the battery 16 helps to preserve the quality of the connection between the battery 16 and the PCB 12, in the event that the circuit is subjected to comparatively high levels of radially applied shock or vibration.

The support layer 24 does not need to provide any functionality for the electrical circuit, although this option is not excluded and could be utilised. Using a simple flat lamination with no tracks or component fitting holes means that the support layer 24 is simple and cheap to implement and yet provides lateral support to the battery 16, whilst at the same time also adding stiffness to the PCB 12 after bonding/lamination and thereby improving the resistance of the circuit to damage through flexure. The support layer 24 also locates the battery 16 during placement and soldering and this is better than relying for that on the casing 22 alone, which would necessitate close tolerances in battery placement.

The portable control unit 10 is suitable for use as a remote control unit for many appliances, e.g. televisions, sound systems or security systems. Because the present invention provides improved lateral support for the battery 16, it is especially useful when the circuit is used in a remote transponder of a vehicle security system, as outlined below.

It is known in industrial design to try and make sure many items are capable of surviving a so-called "1 metre drop-test", the test being intended to simulate a user dropping the item concerned from about waist height onto a hard surface. It is, however, quite easy to envisage circumstances when an item might be subjected to a much more severe shock.

If someone throws their car keys to a friend and that person does not catch the keys, for example from a third storey window of a building, the keys might land on a hard surface from a height of about 10 metres. If a remote transponder is attached to the keys, the deceleration on impact with the hard surface may subject the battery terminations to a radial load in the order of 200 kg. This could cause weld-tag-type connections to shear and might interrupt the power supply to the associated security circuit PCB, which would almost certainly reduce the efficiency of the remote transponder.

In a variation of the invention, it would also be possible to form the recess by sinking/forming a blind hole directly through one or more layers of the PCB 12. Using this technique, however, would be a non-conventional but critical operation in the PCB manufacturing process. There would also be a conflict between the depth of the feature and potential weakening of the PCB 12. Furthermore, for reliable connection it would be necessary to joggle the tag 20 on the lower face of the battery 16 up to the PCB upper surface. If, however, a user can make it economically or technically worthwhile to implement the invention by using a blind hole, then this variation may prove useful as it might be possible to integrate the battery support with the PCB 12 without providing the support layer 24.

It may also prove advantageous to stick the battery 16 in position in the recess in any variation, e.g. by using adhesive, so as to provide even further increased resistance to lateral/radial and/or axial displacement. In this case, the adhesive, or another form of bonding, could stick the battery 16 to the surface 28 and/or to the PCB 12.

In each embodiment, it can be seen that the integration of the support layer with the PCB provides support for the battery so as to help reduce the likelihood of electrical circuit failure and does so in a manner which is cheaper and simpler to implement than some battery support arrangements disclosed in the prior art.

It should be noted that, although the invention has been described using "coin cells" whose potential lateral displacement is in a radial direction, other shapes of cell could be used. Whatever shape of power supply cell is used, it should be noted that its profile should be substantially complimented by the recess/hole such that lateral displacement of the power supply substantially along the plane of the support layer is opposed.

## Claims

1. An electrical circuit (10) suitable for use in a portable electrical appliance, the circuit comprising a circuit board (12) which includes a support means for supporting a power supply means (16) which is connected to the circuit board, the support means comprising a substantially planar support layer (24) having defined therein a recess (26) which substantially complements a profile of the power supply means, such that a surface (28) which at least in part defines the recess opposes lateral displacement of the power supply means substantially along a plane of said support layer, characterised in that the support layer (24) is integrated with the circuit board (12).

2. A circuit according to Claim 1, wherein the support layer (24) comprises a layer of the circuit board (12).

3. A circuit according to Claim 2, the circuit board (12) comprising a printed circuit board (PCB) and the support layer (24) comprising a laminated layer of said printed circuit board (PCB).

4. A circuit according to any preceding claim, wherein the support layer (24) includes at least one relief portion (180, 200) which is arranged to accommodate a connecting means (18, 20) for connecting the power supply means (16) to the circuit board (12).

5. A circuit according to any preceding claim, wherein the recess (26) is defined as a blind hole.

6. A circuit according to any one of Claims 1 to 4, wherein the recess (26) is defined as a hole extending substantially through at least the support layer (24).

7. A circuit according to any preceding claim, wherein the power supply means (16) is adhesively bonded and/or soldered in place.

8. A circuit according to any preceding claim, the circuit board (12) being included in a remote control unit (10).

9. A circuit according to Claim 8, the remote control unit (10) comprising a remote transponder of a vehicle security system.
